# EUROPEAN PATENT APPLICATION

(11) **EP 4 576 200 A1**
(43) Date of publication of application: **25.06.2025**
(21) Application number: 24220483.2
(22) Date of filing: 17.12.2024
(51) Int. Cl.: H01L 23/373, H01L 23/433

(54) **POWER SEMICONDUCTOR MODULE AND POWER CONVERTER INCLUDING THE SAME**

(30) Priority: 19.12.2023 KR 20230186365; 07.08.2024 KR 20240105726
(71) Applicant: LX Semicon Co., Ltd., Daejeon 34027 (KR)
(72) Inventor: LEE, In Hwan, 34027 Daejeon (KR); KIM, Deog Soo, 34027 Daejeon (KR); KIM, Tae Ryong, 34027 Daejeon (KR)
(74) Representative: Ter Meer Steinmeister & Partner

(57) **Abstract**

A power semiconductor module according to an embodiment may include a first substrate, a power semiconductor device bonded to the first substrate, a second substrate bonded to the power semiconductor device, a heat dissipation post bonded to the second substrate, and a molding member surrounding the first substrate, the power semiconductor device, the second substrate, and the heat dissipation post.

In addition, a top surface of the heat dissipation post may be exposed through the molding member. In addition, a height of a top surface of the heat dissipation post may be the same as a height of the top surface of the molding member. In addition, the heat dissipation post may vertically overlap the power semiconductor device.

## Description

### BACKGROUND

### Field of the Disclosure

The present disclosure relates to a power semiconductor module, a manufacturing method thereof, and a power converter including the same.

### Description of the related art

A power converter module is a device that performs power converting (AC->DC, DC->AC), power transformation (step-down, step-up), power distribution, or power control functions. The power converter module is a core component that performs the function of improving energy efficiency in the process of transmitting and controlling power, and controlling voltage changes to provide system stability and reliability, and is referred to as a power module or a power system.

A power converter module includes various components such as a power semiconductor device, a heat dissipation substrate, a base plate, molded silicon, a case or a cover, and a terminal.

Recently, eco-friendly cars based on electricity or hydrogen are in the spotlight instead of fossil fuel-based internal combustion engine cars, and numerous power semiconductor devices are used in these eco-friendly cars. Eco-friendly vehicles include hybrid electric vehicles (HEVs), plug-in hybrid electric vehicles (PHEVs), electric vehicles (EVs), and fuel cell electric vehicles (PCEVs).

In addition to eco-friendly vehicles, power semiconductors are also used in various electric and electronic devices such as electric vehicle chargers, energy storage devices, power supply devices, and railways.

Previously, silicon (Si) power semiconductor devices were widely used, but as Si power semiconductors reached their physical limits, research on WBG (Wide Bandgap) power semiconductors such as silicon carbide (SiC) or gallium nitride (GaN) to replace them is actively being conducted.

WBG power semiconductor devices have approximately three times the bandgap energy of Si power semiconductor devices, approximately ten times the dielectric breakdown field of Si power semiconductor devices, and approximately three times higher thermal conductivity than Si power semiconductor devices. Due to these excellent characteristics, WBG power semiconductor devices can operate in high temperature and high voltage environments and have the advantages of high switching speed and low switching loss.

For example, Si-based power semiconductor modules used to perform power conversion (DC↔AC), motor drive switching etc. in conventional electric vehicles or hybrid electric vehicles., were operated in a temperature environment of about 150°C. But recently, due to the demand for increased switching performance and power density, research is actively being conducted on power semiconductor devices based on wide band gap (WBG) such as SiC or GaN that can operate at a usage temperature of about 300°C or higher, for example, at about 300~700°C.

Meanwhile, heat generated from power semiconductors generates thermo-mechanical stress in each part of the power semiconductor module, and the life of the junction and power semiconductor device may be deteriorated due to thermal fatigue at the junction. Therefore, the reliability design of the power semiconductor module that appropriately releases the heat generated from the power semiconductor device through the heat dissipation substrate and maintains the junction temperature of the power semiconductor device below an appropriate temperature is very important.

Meanwhile, the heat dissipation substrate for power semiconductors has the function of transmitting the heat generated during the operation of the power semiconductor device to the outside, also a circuit pattern is formed on one side of the heat-dissipating substrate which plays an important role in electrically connecting power semiconductor devices.

Conventional heat-dissipating substrates for power semiconductors may be classified into DBC (direct bonded copper) and AMB (active metal brazing) methods depending on the bonding method. The DBC method is a method of forming an oxide film on a copper (Cu) layer and then directly bonding it to ceramic. The AMB method is a method of performing brazing by interposing a paste containing relatively low melting point metal particles between the base metal and ceramic.

However, high-voltage/high-power such as 1200V/200A SiC power converter modules are being used recently to improve the performance of hybrid and electric vehicles and autonomous vehicles, and the operating temperature of power semiconductor devices during operation of these high-performance electric vehicles requires an average of 300°C or higher. In addition, these high-performance electric vehicles are facing an ultra-high temperature usage state with an instantaneous maximum operating temperature of 350°C or higher.

In such an ultra-high temperature, high voltage, and high current operating environment, existing bonding materials themselves may be re-melted, and heat trapping may occur due to pores existing in the joint, which may rapidly deteriorate the life of the power semiconductor module.

For example, cracks may occur due to defects induced at the interface between the ceramic substrate of the heat-dissipating substrate and the copper (Cu) sheet. And such cracks induced in the heat-dissipating substrate may cause thermal runaway, leading to the destruction of the power semiconductor device.

For example, if the heat dissipation performance is reduced due to cracks in the heat-dissipating substrate, the power semiconductor module case and surrounding temperature may increase. At this time, if the heat generation exceeds the heat dissipation performance due to the rapid temperature increase (heat generation state > heat dissipation performance), the thermal equilibrium state (heat generation state < heat dissipation performance) according to the thermal design cannot be maintained, and heat generation continues to increase. As a result, the leakage current continues to increase, ultimately leading to the destruction of the power semiconductor module itself.

In particular, in the case where the deterioration problem of the power semiconductor module occurs in an ultra-high operating temperature environment, the destruction of the power semiconductor device due to malfunction of the power semiconductor module mounted on the vehicle can have a serious impact on the safety of the driver.

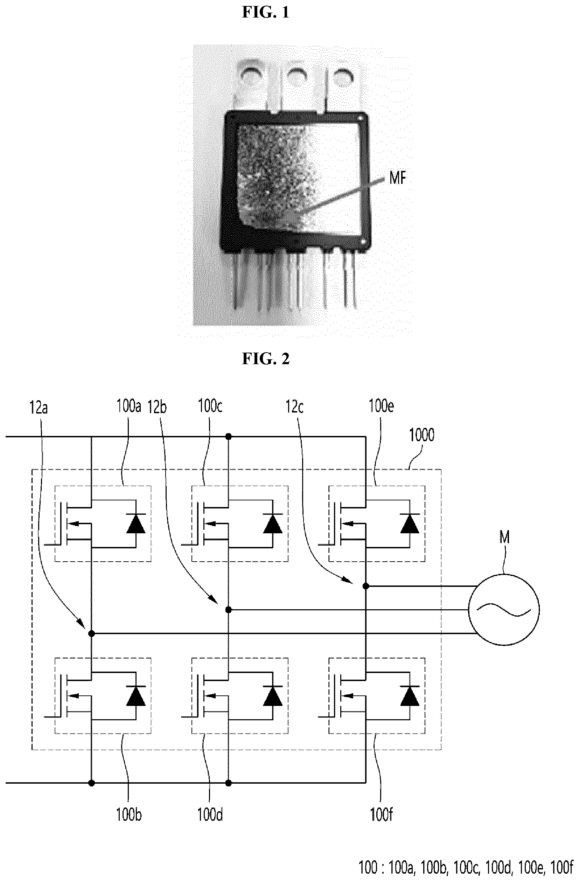

FIG. 1 is a photograph of the appearance of a power semiconductor module package according to the related art.

Among the power semiconductor modules according to the related art, there is DSC (Dual Side Cooling) technology.

The conventional DSC power semiconductor module is flip-chip bonded to an upper heat dissipation substrate and a lower heat dissipation substrate so that a gate electrode and a source electrode of the power semiconductor device face the heat dissipation substrate. In addition, a spacer structure is interposed and bonded on a lower side of the drain electrode of the power semiconductor device.

However, according to the related art, since the power semiconductor device and the spacer structure are laminated together, there is a problem that a height variation of the module may occur, and thus, damage to the component may occur when pressure is applied with a press jig. `Height variation' may be expressed as 'height tolerance' or `height difference'.

In addition, according to the related art, there is a problem that thermal or mechanical reliability problems may occur between the components due to the height variation between the components.

In addition, according to the related art, there is a possibility that appearance defects (Mold flash: MF) may occur during EMC transfer molding due to the height variation of the module.

Meanwhile, in the case of modularization with thermal or mechanical reliability problems between the components, the power semiconductor module may rapidly deteriorate in an ultra-high temperature operating temperature environment close to 300°C, and there is a problem that the power semiconductor device may be destroyed due to malfunction of the power semiconductor module mounted on the vehicle, which may have a serious impact on the driver's safety.

Meanwhile, power semiconductor modules used in inverters such as electric vehicles perform high-speed switching operations with multiple power semiconductor devices disposed in series or parallel, and thus electromagnetic interference (EMI) may occur inside the power semiconductor module, or electromagnetic noise may occur from the outside, which may cause problems with electromagnetic susceptibility (EMS).

Meanwhile, if a malfunction occurs in high-speed switching of the power semiconductor device due to EMI or EMS problems in the power semiconductor module mounted on a vehicle, there is a problem that may have a serious impact on the driver's safety.

### SUMMARY

One of the technical objects of the embodiment is to provide a power semiconductor module, a method for manufacturing the same, and a power converter including the same capable of preventing assembly failure or thermal, mechanical, and electrical reliability problems due to height variation of components of the power semiconductor module.

In addition, one of the technical objects of the embodiment is to provide a power semiconductor module, a method for manufacturing the same, and a power converter including the same capable of preventing malfunctions in high-speed switching of power semiconductor elements due to EMI or EMS problems in the power semiconductor module.

The technical objects of the embodiment are not limited to those described in this item, and include those that may be understood through the description of the invention.

The power semiconductor module according to an embodiment may include a first substrate (210), a power semiconductor device (100) bonded to the first substrate (210), a second substrate (220) bonded to the power semiconductor device (100), a heat dissipation post (310) bonded to the second substrate (220), and a molding member (320) to surround the first substrate (210), the power semiconductor device (100), the second substrate (220), and the heat dissipation post (310).

A top surface of the heat dissipation post (310) may be exposed from a top surface of the molding member (320).

A height of the top surface of the heat dissipation post (310) may be the same as the height of the top surface of the molding member (320).

The heat dissipation post (310) may vertically overlap the power semiconductor device.

The heat dissipation post (310) may be grounded.

The second substrate (220) may include a metal plate. The metal plate of the second substrate may be grounded.

The power semiconductor device may include a first power semiconductor device and a second power semiconductor device spaced apart from each other on the first substrate. The second substrate may include a second-first substrate bonded to the first power semiconductor device and a second-second substrate spaced apart from the second-first substrate and bonded to the second power semiconductor device.

The power semiconductor device may include a first power semiconductor device and a second power semiconductor device spaced apart from each other on the first substrate. The second substrate (220) may include a second-second substrate bonded to the second power semiconductor device and a second-third substrate spaced apart from the second-second substrate and bonded to the first power semiconductor device. The power semiconductor device may further include a conductive member (190) between the first substrate and the second-third substrate.

The molding member may include a molding recess (320R) on its top surface. A side surface of the heat dissipation post (310) may be exposed through the molding recess (320R).

The gate electrode of the power semiconductor device may be electrically connected to the first substrate by a wire. The top surface of the heat dissipation post may be higher than the top surface of the molding member.

The protruding heat dissipation post (320P) higher than the top surface of the molding member may include a third-first heat dissipation post (313a) disposed on the inside of the molding member and a third-second heat dissipation post (313b) disposed on the outside of the molding member.

A power converter according to the embodiment may include any one of the power semiconductor modules.

A power semiconductor module according to the embodiment may include a first substrate, a power semiconductor device bonded to a first substrate, a second substrate bonded to the power semiconductor device, a protruding heat dissipation post bonded to the second substrate and a molding member configured to surround the first substrate, the power semiconductor device, and the second substrate.

A top surface of the protruding heat dissipation post may be exposed from a top surface of the molding member. The protruding heat dissipation post may include a third-first heat dissipation post arranged on an inside of the molding member and a third-second heat dissipation post disposed on an outside of the molding member. The protruding heat dissipation post may be grounded. The second substrate may include a metal plate. The metal plate of the second substrate may be grounded. The second substrate may include a metal plate. The protruding heat dissipation post may be in contact with the metal plate of the second substrate. The metal plate of the second substrate may be grounded.

According to the embodiment, there is a technical effect that can prevent assembly failure or thermal, mechanical, and electrical reliability problems due to height variation of components of the power semiconductor module. For example, according to the embodiment, the power semiconductor device may be disposed between the first substrate (210) and the second substrate (220), and since additional structures such as separate spacers may be omitted, there is a technical effect that can prevent assembly failure problems due to height variation of components of the power semiconductor module.

In addition, according to the embodiment, the power semiconductor device may be disposed between the first substrate (210) and the second substrate (220), and since additional structures such as separate spacers may be omitted, the pressure applied to the power semiconductor device or the substrate during the pressing process with the press jig can be reduced, and thus there is a technical effect that can prevent thermal, mechanical, and electrical reliability problems.

In addition, according to the embodiment, the heat dissipation performance may be improved by placing the heat dissipation post in a position corresponding to a vertical direction of the power semiconductor device in consideration of the heat dissipation distribution on the substrate.

In addition, according to the embodiment, there is a technical effect that can prevent problems such as malfunctions in high-speed switching of the power semiconductor device due to EMI or EMS problems in the power semiconductor module.

For example, according to the embodiment, there is a technical effect that can prevent problems such as malfunctions in high-speed switching of the power semiconductor device due to EMI or EMS problems in the power semiconductor module by placing a metal heat dissipation post that can block static electricity or electromagnetic waves in a position that overlaps the power semiconductor device in the vertical direction.

For example, according to the embodiment, a metal heat dissipation post capable of blocking static electricity or electromagnetic waves may be disposed at a position that overlaps the power semiconductor device in a vertical direction, and the second plate (220m) of the second substrate (220) that comes into contact with the heat dissipation post may be grounded, thereby preventing malfunctions of high-speed switching of the power semiconductor device in the power semiconductor module due to EMI or EMS problems.

In addition, according to the embodiment, the appearance defect of the EMC molding can be prevented by forming a molding member by grinding (G) after overcoating to a position higher than the heat dissipation post (310) so that the heat dissipation post (310) may be exposed.

In addition, the embodiment can control the height of the heat dissipation post in consideration of the product specifications, and has the technical effect of accurately controlling the thickness or height of the product specifications as the molding process proceeds thereafter.

The technical effects of the embodiment are not limited to those described in this article and include those that may be understood through the description of the invention.

### BRIEF DESCRIPTION OF THE DRAWINGS

FIG. 1 is an external photograph of a power semiconductor module package according to the related art.
FIG. 2 is an example diagram of a power converter (1000) according to the embodiment.
FIG. 3 is a cross-sectional view of a power semiconductor device (100) according to the embodiment.
FIG. 4 is a cross-sectional view of a power semiconductor module (501) according to a first embodiment.
FIGS. 5A to 6B are cross-sectional views of a manufacturing process of a power semiconductor module (501) according to the first embodiment.
FIG. 7 is a cross-sectional view of a power semiconductor module (502) according to a second embodiment.
FIG. 8 is a cross-sectional view of a power semiconductor module (503) according to a third embodiment.
FIG. 9 is a cross-sectional view of a power semiconductor module (504) according to a fourth embodiment.
FIG. 10 is a cross-sectional view of a power semiconductor module (505) according to a fifth embodiment.
FIG. 11 is a cross-sectional view of a power semiconductor module (506) according to a sixth embodiment.

### DETAILED DESCRIPTION

Hereinafter, the invention according to the embodiment for solving the above problem will be described in more detail with reference to the drawings.

The suffixes "module" and "part" used for elements in the following description are given simply for the convenience of writing this specification, and do not in themselves give a particularly important meaning or role. In addition, the "module" and "part" may be used interchangeably.

Terms including ordinal numbers such as first, second, etc. may be used to describe various elements, but the elements are not limited by the terms. The terms are used only for the purpose of distinguishing one element from another element.

The singular expression includes a plural expression unless the context clearly indicates otherwise.

In the present application, the terms "includes" or "has" are intended to specify the presence of a feature, number, step, operation, component, part, or combination thereof described in the specification, and should be understood as not excluding in advance the possibility of the presence or addition of one or more other features, numbers, steps, operations, components, parts, or combinations thereof.

In the embodiment, the power semiconductor module may be used in inverters or converters for automobiles, computers, home appliances, solar power, smart grids, etc. In addition, the power semiconductor module according to the embodiment may be applied to various electric and electronic devices such as electric vehicle chargers, power supply devices, or railways in addition to eco-friendly automobiles.

In addition, the heat dissipation substrate for power semiconductors according to the embodiment may be mounted and used in power semiconductor modules used in inverters or converters for automobiles, computers, home appliances, solar power, smart grids, etc. In addition, the heat dissipation substrate for power semiconductors according to the embodiment may be mounted and used in power semiconductor modules mounted in various electric and electronic devices such as electric vehicle chargers, power supply devices, or railways in addition to eco-friendly automobiles.

In the embodiment, the power semiconductor device may include one power semiconductor module or multiple power semiconductor modules. In addition, the power semiconductor module may include multiple power semiconductor devices.

In the embodiment below, the power semiconductor device describes an inverter for driving a motor for an automobile, but the power semiconductor device of the embodiment may be applied to inverters or converters in various technical fields described above. Here, the automobile includes a hybrid vehicle (HEV), a plug-in hybrid vehicle (PHEV), an electric vehicle (EV), a fuel cell vehicle (PCEV), etc. In the description of the embodiment below, the switching device and the power semiconductor device may be used interchangeably.

### <Power Converter>

FIG. 2 is an example view of a power converter (1000) according to the embodiment.

The power converter (1000) according to the embodiment may receive DC power from a battery or a fuel cell, convert it into AC power, and supply AC power to a predetermined load. For example, the power converter (1000) according to the embodiment may include an inverter, and may receive DC power from a battery, convert it into three-phase AC power, and supply it to a motor (M), and the motor (M) may provide power to an electric vehicle, a fuel cell vehicle, etc.

The power converter (1000) according to the embodiment may include a power semiconductor device (100). The power semiconductor device (100) may be a MOSFET (Metal Oxide Semiconductor Field Effect Transistor) and may include an IGBT (Insulated Gate Bipolar Transistor), but is not limited thereto.

For example, the power converter (1000) may include a plurality of power semiconductor devices (100a, 100b, 100c, 100d, 100e, 100f) and may include a plurality of diodes (not shown). Each of the above plurality of diodes may be embedded in the power semiconductor devices (100a, 100b, 100c, 100d, 100e, 100f) in the form of internal diodes, but is not limited thereto, and may be disposed separately.

The embodiment may convert DC power into AC power through on-off control for the plurality of power semiconductor devices (100a to 100f). For example, the power converter (1000) according to the embodiment may supply positive power to the motor (M) by turning on the first power semiconductor device (100a) and turning off the second power semiconductor device (100b) in the first-time section of one cycle. The power converter (1000) may supply negative power to the motor (M) by turning off the first power semiconductor device (100a) and turning on the second power semiconductor device (100b) in the second-time section of one cycle.

In the embodiment, a group of power semiconductor devices disposed in series on the high-voltage line and the low-voltage line of the input side may be called an arm. For example, the first power semiconductor device (100a) and the second power semiconductor device (100b) may constitute a first arm (12a), the third power semiconductor device (100c) and the fourth power semiconductor device (100d) may constitute a second arm (12b), and the fifth power semiconductor device (100e) and the sixth power semiconductor device (100f) may constitute a third arm (12c).

In the arm, the upper power semiconductor device and the lower power semiconductor device may be controlled not to be turned on at the same time. For example, in the first arm (12a), the first power semiconductor device (100a) and the second power semiconductor device (100b) may not be turned on at the same time but may be turned on and off alternately.

Each power semiconductor device (100a to 100f) may be supplied with high power while in the off state. For example, when the first power semiconductor device (100a) is turned on and the second power semiconductor device (100b) is turned off, the input voltage may be applied as it is to the second power semiconductor device (100b). The voltage input to the second power semiconductor device (100b) may be a relatively high voltage, and the withstand voltage of each power semiconductor device (100a to 100f) may be designed to be high to withstand this high voltage.

Each power semiconductor device (100a to 100f) can conduct a high current in the turned-on state. The motor (M) may be driven by a relatively high current, and this high current may be supplied to the motor (M) through the power semiconductor that is turned on.

The high voltage applied to each power semiconductor device (100a to 100f) can cause a high switching loss. The high current conducting the power semiconductor device (100a to 100f) may cause a high conduction loss. To dissipate the heat generated by such loss, the power semiconductor device (100a to 100f) may be packaged as a power semiconductor module including a heat dissipation means.

The power semiconductor device (100) of the embodiment may be a silicon carbide (SiC) power semiconductor device, and may be capable of operating in a high temperature and high voltage environment and may have a high switching speed and low switching loss.

Meanwhile, the power converter (1000) according to the embodiment may include a plurality of power semiconductor modules.

For example, the plurality of power semiconductor devices (100a to 100f) illustrated in FIG. 2 may be packaged as one power semiconductor module, or the power semiconductor devices constituting each arm may be packaged as one power semiconductor module.

For example, the first power semiconductor device (100a), the second power semiconductor device (100b), the third power semiconductor device (100c), the fourth power semiconductor device (100d), the fifth power semiconductor device (100e), and the sixth power semiconductor device (100f) illustrated in FIG. 2 may be packaged as one power semiconductor module.

In addition, an additional power semiconductor device may be disposed in parallel with each power semiconductor device (100a to 100f) to increase the current capacity. In this case, the number of power semiconductor devices included in the power semiconductor module may be more than 6.

The power converter (1000) according to the embodiment may include a power semiconductor device in the form of a diode in addition to the power semiconductor devices (100a to 100f) in the form of a transistor. For example, a first diode (not shown) may be disposed in parallel with the first power semiconductor device (100a), and a second diode (not shown) may be disposed in parallel with the second power semiconductor device (100b). In addition, these diodes may also be packaged together in one power semiconductor module. In addition, the diodes may be disposed in the form of an internal diode in each power semiconductor device.

Next, the power semiconductor devices constituting each arm may be packaged in one power semiconductor module.

For example, the first power semiconductor device (100a) and the second power semiconductor device (100b) that constitute the first arm (12a) may be packaged as the first power semiconductor module, the third power semiconductor device (100c) and the fourth power semiconductor device (100d) that constitute the second arm (12b) may be packaged as the second power semiconductor module, and the fifth power semiconductor device (100e) and the sixth power semiconductor device (100f) that constitute the third arm (12c) may be packaged as the third power semiconductor module.

In addition, in order to increase the current capacity, there may be additional power semiconductor devices disposed in parallel with each power semiconductor device (100a to 100f), and in this case, the number of power semiconductor devices included in each power semiconductor module may be more than two. In addition to the transistor-type power semiconductor devices (100a to 100f), each arm may also include a diode-type power semiconductor device (not shown), and these diodes may also be packaged together in one power semiconductor module. In addition, the diode may be disposed in the form of an internal diode in each power semiconductor device.

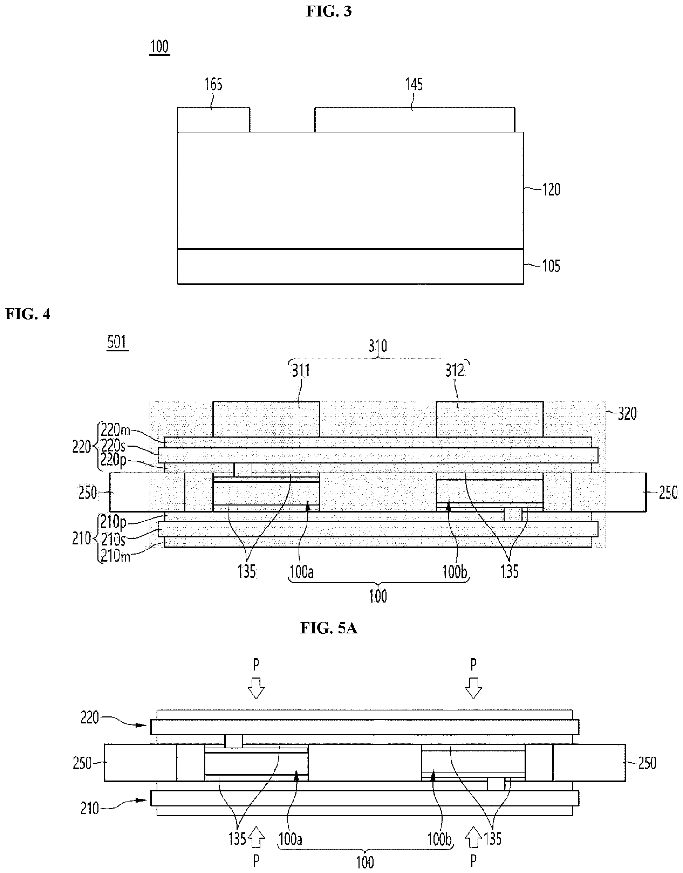

Next, FIG. 3 is a cross-sectional view of a power semiconductor device (100) according to an embodiment.

The power semiconductor device (100) according to the embodiment may include a source electrode (145), a gate electrode (165) disposed on an upper side of a semiconductor epi layer (120), and a drain electrode (105) disposed on a lower side of the semiconductor epi layer (120).

In the form of a MOSFET, the source electrode (145) or the gate electrode (165) may include an Al based metal, and the drain electrode (105) may include a Ti/Ni/Ag metal including a Ti layer, a Ni layer, and an Ag layer, or NiV/Ag, V(vanadium)/Ni/Ag, etc., but is not limited thereto. The Al based metal may be Al or Al alloy.

As described above, one of the technical objects of the embodiment is to provide a power semiconductor module, a manufacturing method thereof, and a power converter including the same, which can prevent assembly failures or thermal, mechanical, and electrical reliability problems due to height variations of components of the power semiconductor module.

In addition, one of the technical objects of the embodiment is to provide a power semiconductor module, a manufacturing method thereof, and a power converter including the same, which can prevent malfunctions in high-speed switching of the power semiconductor device due to EMI or EMS problems in the power semiconductor module.

Hereinafter, embodiments that can solve the technical problem of the embodiment will be described in detail.

### (First Embodiment)

FIG. 4 is a cross-sectional view of a power semiconductor module (501) according to a first embodiment. Hereinafter, the 'first embodiment' may be abbreviated as 'embodiment'.

Referring to FIG. 4, the power semiconductor module (501) according to the first embodiment may include a first substrate (210), a second substrate (220), and a conductive frame (250). A plurality of power semiconductor devices (100) may constitute one sub-module. The first substrate (210) and the second substrate (220) may be heat-radiating substrates.

For example, the sub-module may include a first power semiconductor device (100a) and a second power semiconductor device (100b). Referring briefly to FIG. 3, the first power semiconductor device (100a) or the second power semiconductor device (100b) may include a semiconductor epi layer (120), a source electrode (145), a gate electrode (165), and a drain electrode (105).

Referring back to FIG. 4, the first power semiconductor device (100a) and the second power semiconductor device (100b) may constitute one arm. For example, the first power semiconductor device (100a) and the second power semiconductor device (100b) may have electrodes disposed in opposite directions. For example, the source electrode and the gate electrode of the first power semiconductor device (100a) may be disposed upward, and the drain electrode may be disposed downward. In addition, the source electrode and the gate electrode of the second power semiconductor device (100b) may be disposed downward, and the drain electrode may be disposed upward. In this arrangement structure, the first power semiconductor device (100a) and the second power semiconductor device (100b) may form one arm.

In addition, when the electrodes of the first power semiconductor device (100a) and the second power semiconductor device (100b) are disposed in the same direction, the first power semiconductor device (100a) and the second power semiconductor device (100b) may be electrically connected in parallel.

Meanwhile, the first power semiconductor device (100a) may be disposed between the first substrate (210) and the second substrate (220) and may be bonded by a first adhesive member (135). In addition, the second power semiconductor device (100b) may be disposed between the first substrate (210) and the second substrate (220) and may be bonded by another first adhesive member (135).

The first adhesive member (135) may be a Sn-Ag based adhesive member or an Ag based adhesive member. The first adhesive member (135) may be pasted between the first substrate (210) and the second substrate (220), but is not limited thereto. In addition, the power semiconductor device (100) may be bonded through sintering, but is not limited thereto.

Referring to FIG. 4, the first substrate (210) and the second substrate (220) may be heat dissipation substrates. For example, the first substrate (210) may include a first insulating substrate (210s), a first plate (210m) under the first insulating substrate (210s), and a first circuit pattern (210p) on the first insulating substrate (210s).

In addition, the second substrate (220) may include a second insulating substrate (220s), a second circuit pattern (220p) under the second insulating substrate (220s), and a second plate (220m) on the second insulating substrate (220s).

The first insulating substrate (210s) and the second insulating substrate (220s) may include a polycrystalline insulating substrate made of a ceramic material having high thermal conductivity. For example, the first insulating substrate (210s) and the second insulating substrate (220s) may be one of AlN or Si₃N₄, or may be Al₂O₃, but are not limited thereto. In addition, the first insulating substrate (210s) and the second insulating substrate (220s) may include a single crystal substrate such as a sapphire substrate.

The first plate (210m) and the second plate (220m) may include a Cu-based metal, but are not limited thereto.

Referring back to FIG. 1, among the power semiconductor modules according to the related art, a DSC (Dual Side Cooling) technology has a problem that the height variation of the module may occur as the power semiconductor device and the spacer structure are laminated together such that damage to the parts may occur when pressure is applied with a press jig.

In particular, since many parts such as the power semiconductor device and the spacer structure are laminated together, the pressure of the press jig is to be applied with greater pressure, so there is a problem that damage to the parts may occur.

In addition, according to the related art, there is a problem that thermal or mechanical reliability problems may occur between the parts as the degree of adhesion is different for each power semiconductor device and the location is different when pressing due to the height variation between the parts.

In addition, according to the related art, there is a possibility that appearance defects (Mold flash: MF) may occur during EMC transfer molding due to the height variation of the module.

In addition, according to the related art, when a power semiconductor chip is placed on a heat-dissipating substrate by interposing a predetermined paste and applying pressure with a press jig, a height variation may occur as the power semiconductor device and the spacer structure are laminated together, or when applying pressure with the press jig, a misalignment may occur between the circuit pattern on the heat-dissipating substrate and the power semiconductor chip due to the occurrence of inclination.

For example, when applying pressure to a power semiconductor chip with a press jig, a rotated chip (R-chip) or a shifted chip (S-chip) may occur, causing a misalignment between the circuit pattern on the heat-dissipating substrate and the power semiconductor chip, resulting in a problem of electrical short-circuit or disconnection.

In particular, since the size of the gate electrode or source electrode is small as the power semiconductor device becomes compact, there is a problem that the electrical contact of the electrodes is defective even if the power semiconductor device is slightly out of the original position.

In addition, the power semiconductor module used in the inverter of an electric vehicle performs a high-speed switching operation in a state where multiple power semiconductor devices are disposed in series or parallel. So, electromagnetic interference (EMI: Electromagnetic Interference) may occur inside the power semiconductor module, or electromagnetic noise may occur from the outside, causing a problem in electromagnetic susceptibility (EMS: Electromagnetic Susceptibility). If a malfunction occurs in the high-speed switching of the power semiconductor device due to EMI or EMS problems in the power semiconductor module mounted on the vehicle, there is a problem that may seriously affect the safety of the driver.

The first embodiment may include a heat dissipation post (310) disposed on the second substrate (220), and may include a first molding member (320) that may surround the first substrate (210), the second substrate (220), and the conductive frame (250).

For example, the heat dissipation post (310) may be disposed at a position that overlaps the first power semiconductor device (100a) and the second power semiconductor device (100b) vertically.

For example, the heat dissipation post (310) may include a first heat dissipation post (311) to overlap the first power semiconductor device (100a) and a second heat dissipation post (312) to overlap the second power semiconductor device (100b).

The heat dissipation post (310) may be a thermally conductive material. For example, the heat dissipation post (310) may be a metal material such as Cu, but is not limited thereto.

The heat dissipation post (310) may be bonded to the second substrate (220) using a predetermined adhesive member (not shown). In addition, the heat dissipation post (310) may be bonded through ultrasonic bonding so that less pressure or heat may be transferred to the first power semiconductor device (100a) or the second power semiconductor device (100b).

According to the embodiment, there is a technical effect that can prevent assembly failure or thermal, mechanical, and electrical reliability problems due to height variation of components of the power semiconductor module.

For example, according to the embodiment, the power semiconductor device may be disposed between the first substrate (210) and the second substrate (220), and since additional structures such as separate spacers may be omitted, there is a technical effect that can prevent assembly failure problems due to height variation of components of the power semiconductor module.

In addition, according to the embodiment, the power semiconductor device may be disposed between the first substrate (210) and the second substrate (220), and since additional structures such as separate spacers may be omitted, the pressure applied to the power semiconductor device or the substrate during the pressing process with the press jig can be reduced, thereby preventing thermal, mechanical, and electrical reliability problems.

In addition, according to the embodiment, the heat dissipation performance may be improved by placing the heat dissipation post in a position corresponding to the vertical direction of the power semiconductor device in consideration of the heat dissipation distribution on the substrate.

In addition, according to the embodiment, there is a technical effect of preventing problems such as malfunctions in high-speed switching of the power semiconductor device due to EMI or EMS problems in the power semiconductor module.

For example, according to the embodiment, since a metal heat dissipation post capable of blocking static electricity or electromagnetic waves may be disposed in a position to overlap the power semiconductor device in a vertical direction, there is a technical effect that can prevent malfunctions in the power semiconductor module, such as high-speed switching, due to EMI or EMS problems.

For example, since the heat dissipation post can reduce the impedance of the ground line, there is an effect that can prevent malfunctions in the power semiconductor module that performs high-speed switching due to EMI or EMS problems. In addition, in the embodiment, the heat dissipation post or the second plate (220m) of the second substrate (220) that comes into contact with the heat dissipation post may be grounded.

Conventionally, the second plate (220m) of the second substrate (220), which is not electrically connected to the power semiconductor device, has a heat dissipation function, so the second plate (220m) of the second substrate (220) is not grounded.

On the other hand, according to the embodiment, a metal heat dissipation post (310) capable of blocking static electricity or electromagnetic waves may be disposed in a position to overlap the power semiconductor device in a vertical direction. In addition, the second plate (220m) of the second substrate (220) in contact with the heat dissipation post (310) may be grounded, thereby providing a special technical effect that can prevent malfunctions of high-speed switching of the power semiconductor device in the power semiconductor module due to EMI or EMS problems.

Hereinafter, the manufacturing process of the power semiconductor module (501) according to the first embodiment will be described with reference to FIGS. 5A to 6B, and the technical features of the first embodiment will be described in detail.

First, referring to FIG. 5A, the first power semiconductor device (100a), the second power semiconductor device (100b), and the conductive frame (250) may be disposed between the first substrate (210) and the second substrate (220) and may be bonded for the first time by the first adhesive member (135).

Specifically, a pick and place process may be performed using a pick up tool so that the first power semiconductor device (100a) and the conductive frame (250) may be bonded on the first substrate (210) by the first adhesive member (135).

In addition, the second power semiconductor device (100b) may be bonded on the second substrate (220) by the first adhesive member (135).

The first adhesive member (135) may be a Sn-Ag based adhesive member or an Ag based adhesive member. The first adhesive member (135) may be pasted on the first substrate (210) and the second substrate (220), but is not limited thereto.

Afterwards, a sintering process may be performed while thermally compressing (P) through a predetermined press jig.

For example, a power semiconductor module may be manufactured by performing secondary bonding by thermally compressing the first substrate (210) and the second substrate (220). The process temperature of the secondary bonding may be 200°C to 300°C, but is not limited thereto.

Meanwhile, the DSC (Dual Side Cooling) technology according to the related art has a problem that the height variation of the module may occur as the power semiconductor device and the spacer structure are laminated together. So, damage may occur to the component when pressure is applied with a press jig. In particular, since many parts, such as power semiconductor devices and spacer structures, are laminated together, the pressure of the press jig is to be applied with greater pressure, which may cause damage to the parts.

In addition, according to the related art, there is a problem that thermal or mechanical reliability problems may occur between the parts as the degree of adhesion is different for each power semiconductor device and the location is different when pressing due to the variation in height between the parts.

In addition, according to the related art, since the power semiconductor device and spacer structures are laminated together, misalignment may occur between the circuit pattern on the heat dissipation substrate and the power semiconductor chip when applying pressure with the press jig due to the occurrence of height variation or tilt.

On the other hand, according to the embodiment, the power semiconductor device may be disposed between the first substrate (210) and the second substrate (220), and since additional structures such as separate spacers may be omitted, there is a technical effect that can prevent problems of assembly failure due to height variation of components of the power semiconductor module.

In addition, according to the embodiment, the power semiconductor device may be disposed between the first substrate (210) and the second substrate (220), and since additional structures such as separate spacers may be omitted, the pressure applied to the power semiconductor device or the substrate during the pressing process with the press jig can be reduced, and thus there is a technical effect that can prevent problems of thermal, mechanical, and electrical reliability.

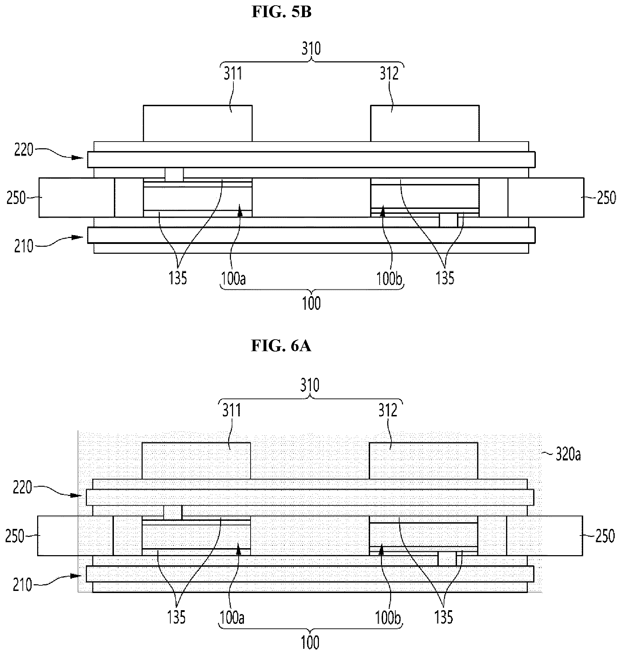

Next, referring to FIG. 5B, a heat dissipation post (310) may be disposed on the second substrate (220). For example, the heat dissipation post (310) may be disposed at a position to overlap the first power semiconductor device (100a) and the second power semiconductor device (100b) vertically.

For example, the heat dissipation post (310) may include a first heat dissipation post (311) to overlap the first power semiconductor device (100a) and a second heat dissipation post (312) to overlap the second power semiconductor device (100b).

The heat dissipation post (310) may be made of a thermally conductive material. For example, the heat dissipation post (310) may be made of a metal material such as Cu, but is not limited thereto.

The heat dissipation post (310) may be bonded to the second substrate (220) using a predetermined adhesive member.

In addition, the heat dissipation post (310) may be bonded through ultrasonic bonding so that less pressure or less heat may be transferred to the first power semiconductor device (100a) or the second power semiconductor device (100b). For example, the ultrasonic bonding technology of the embodiment may vibrate the heat dissipation post (310) and the heat dissipation substrate with an ultrasonic wave of about 20 kHz or more while applying a certain pressure. Accordingly, the bonding surface may be frictionized to induce metal-to-metal contact, and the bonding part may be formed and bonded by frictional heat, etc. The ultrasonic bonding technology of the embodiment can include a horizontal vibration method, but is not limited thereto.

In addition, according to another embodiment, the bonding process of the first substrate (210), the second substrate (220), the first power semiconductor device (100a), and the second power semiconductor device (100b) of FIG. 5A may be performed while the heat dissipation post (310) may be bonded to the second substrate (220).

Next, referring to FIG. 6A, the preliminary molding material (320a) may be overcoated to a position higher than the heat dissipation post (310) using a molding housing (not shown). The above preliminary molding material (320a) may include EMC (Epoxy Molding Compound), but is not limited thereto.

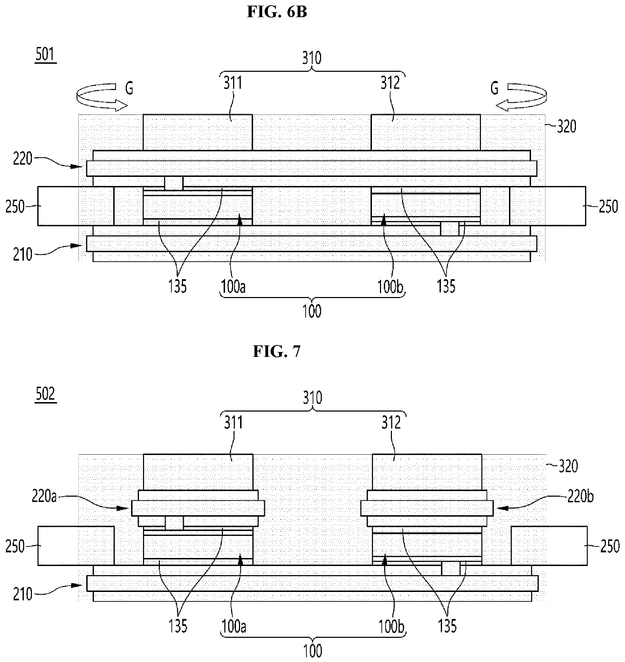

Next, referring to FIG. 6B, the preliminary molding material (620a) may be ground (G) to form the first molding member (320) so that the heat dissipation post (310) may be exposed.

According to the related art, there was a possibility that appearance defects (Mold flash: MF) may occur during EMC Transfer Molding due to the height variation of the module.

On the other hand, according to the embodiment, the first molding member (320) may be overcoated to a position higher than the heat dissipation post (310), thereafter the first molding member (320) may be ground (G) such that the heat dissipation post (310) may be exposed. So, appearance defects of EMC molding can be prevented.

In addition, the embodiment can control the height of the heat dissipation post considering the product specifications, and there is a technical effect that can accurately control the thickness or height of the product specifications as the molding process proceeds thereafter.

In addition, in the embodiment, the heat dissipation post (310) or the second plate (220m) of the second substrate (220) in contact with the heat dissipation post (310) may be grounded.

Accordingly, according to the embodiment, a metal heat dissipation post capable of blocking static electricity or electromagnetic waves may be disposed at a position vertically overlapping the power semiconductor device, and the heat dissipation post or the second plate (220m) of the second substrate (220) in contact with the heat dissipation post may be grounded, so there is a special technical effect that can prevent problems such as malfunctions in high-speed switching of the power semiconductor device due to EMI or EMS problems in the power semiconductor module.

### (Second embodiment)

Next, FIG. 7 is a cross-sectional view of a power semiconductor module (502) according to a second embodiment. The second embodiment may adopt the technical features of the first embodiment, and the main features of the second embodiment will be described below.

Referring to FIG. 7, the power semiconductor module (502) according to the second embodiment may include the first substrate (210), a second-first substrate (220a), a second-second substrate (220b), the conductive frame (250), and the heat dissipation post (310). A plurality of power semiconductor devices (100) may constitute one sub-module. The first substrate (210), the second-first substrate (22a), and the second-second substrate (220b) may be heat dissipation substrates.

The second embodiment may include the first molding member (320) surrounding the first substrate (210), the second-first substrate (220a), the second-second substrate (220b), and the conductive frame (250).

The first power semiconductor device (100a) may be disposed between the first substrate (210) and the second-first substrate (220a) and may be bonded by an adhesive member (135). In addition, the second power semiconductor device (100b) may be disposed between the first substrate (210) and the second-second substrate (220b) and may be bonded by an adhesive member (135). The first adhesive member (135) may be a Sn-Ag based adhesive member or an Ag based adhesive member.

The first substrate (210) may include a first insulating substrate (210s), a first plate (210m) under the first insulating substrate (210s), a first circuit pattern (210p) on the first insulating substrate (210s) (see FIG. 4).

In addition, the second-first, second-second substrate (220a, 220b) may include the second insulating substrate (220s), the second circuit pattern (220p) under the second insulating substrate (220s), and the second plate (220m) on the second insulating substrate (220s) (see FIG. 4).

Hereinafter, the technical features will be described in detail while explaining the manufacturing process of the second embodiment.

First, referring to FIG. 7, the first power semiconductor device (100a) and the conductive frame (250) may be bonded to the first substrate (210) by the first adhesive member (135) using a pick-up tool.

In addition, the second power semiconductor device (100b) may be bonded to the second-second substrate (220b) by the first adhesive member (135). In addition, the second-first substrate (220a) may be bonded to the first power semiconductor device (100a).

Afterwards, a sintering process may be performed while performing thermal compression (P) through a predetermined press jig. For example, a power semiconductor module may be manufactured by performing secondary bonding by thermal compression of the first substrate (210), the second-first substrate (220a), and the second-second substrate (220b).

According to the second embodiment, a power semiconductor device may be disposed between the first substrate (210), the second-first substrate (220a), and the second-second substrate (220b), and since additional structures such as separate spacers may be omitted, there is a technical effect of preventing assembly failures due to height variations of components of the power semiconductor module.

In addition, according to the second embodiment, the power semiconductor device may be disposed between the first substrate (210) and the second substrate (220), and since additional structures such as separate spacers may be omitted, the pressure applied to the power semiconductor device or the substrate during the pressing process with the press jig can be reduced, thereby preventing thermal, mechanical, and electrical reliability problems.

Next, the first heat dissipation post (311) and the second heat dissipation post (312) may be disposed on the second-first substrate (220a) and the second-second substrate (220b), respectively. For example, the first heat dissipation post (311) and the second heat dissipation post (312) may be disposed at positions that overlap the first power semiconductor device (100a) and the second power semiconductor device (100b), respectively.

The heat dissipation post (310) may be made of a thermally conductive material. For example, the heat dissipation post (310) may be made of a metal material such as Cu, but is not limited thereto.

The heat dissipation post (310) may be bonded to the second substrate (220) using a predetermined adhesive.

In addition, the heat dissipation post (310) may be bonded through ultrasonic bonding so that less pressure or heat may be transferred to the first power semiconductor device (100a) or the second power semiconductor device (100b).

Next, a preliminary molding material (not shown) such as EMC may be overcoated to a position higher than the heat dissipation post (310) using a molding housing. Thereafter, as shown in FIG. 7, the preliminary molding material may be ground to form the first molding member (320) so that the heat dissipation post (310) may be exposed.

According to the second embodiment, the first molding member (320) may be overcoated to a position higher than the heat dissipation post (310), thereafter the first molding member (320) may be ground (G). So, the heat dissipation post (310) may be exposed such that appearance defects of EMC molding can be prevented.

In addition, in the second embodiment, the heat dissipation post (310) or the second plate of the second substrate (220) in contact with the heat dissipation post (310) may be grounded. Accordingly, according to the second embodiment, a metal heat dissipation post capable of blocking static electricity or electromagnetic waves may be disposed in a position that overlaps the power semiconductor device in the vertical direction. In addition, the second plate of the second substrate (220) in contact with the heat dissipation post may be grounded, thereby preventing malfunctions of high-speed switching of the power semiconductor device in the power semiconductor module due to EMI or EMS problems.

### (Third embodiment)

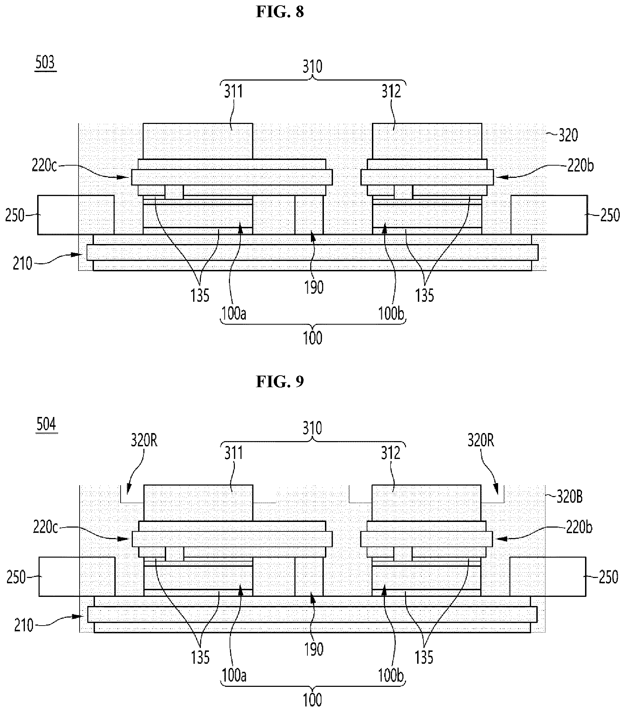

Next, FIG. 8 is a cross-sectional view of the power semiconductor module (503) according to a third embodiment. The third embodiment may adopt the technical features of the first embodiment or the second embodiment, and the main features of the third embodiment will be described below.

Referring to FIG. 8, the power semiconductor module (503) according to the third embodiment may include the first substrate (210), a second-third substrate (220c), a second-second substrate (220b), the conductive frame (250), and the heat dissipation post (310). A plurality of power semiconductor devices (100) may constitute one sub-module. The first substrate (210), the second-third substrate (22c), and the second-second substrate (220b) may be heat dissipation substrates.

The third embodiment may include the first molding member (320) surrounding the first substrate (210), the second-third substrate (220c), the second-second substrate (220b), and the conductive frame (250).

The first power semiconductor device (100a) may be disposed between the first substrate (210) and the second-third substrate (220c) and may be bonded by the adhesive member (135). In addition, the second power semiconductor device (100b) may be disposed between the first substrate (210) and the second-second substrate (220b) and may be bonded by the adhesive member (135). The first adhesive member (135) may be a Sn-Ag based adhesive member or an Ag based adhesive member.

The first substrate (210) may include the first insulating substrate (210s), the first plate (210m) under the first insulating substrate (210s), and the first circuit pattern (210p) on the first insulating substrate (210s) (see FIG. 4).

In addition, the second-third, second-second substrate (220c, 220b) may include the second insulating substrate (220s), the second circuit pattern (220p) under the second insulating substrate (220s), and the second plate (220m) on the second insulating substrate (220s) (see FIG. 4).

Hereinafter, the technical features will be described in detail while explaining the manufacturing process of the third embodiment (503).

Referring to FIG. 8, the conductive frame (250) may be bonded to the first substrate (210) by the first adhesive member (135) using a pick-up tool.

Next, the first power semiconductor device (100a) and a conductive member (190) may be bonded to a second-third substrate (220c) by the first adhesive member (135).

The conductive member (190) may include a metal material such as Cu. In addition, the second power semiconductor device (100b) may be bonded to the second-second substrate (220b) by the first adhesive member (135).

Afterwards, a sintering process may be performed while performing thermal compression (P) through a predetermined press jig. For example, a power semiconductor module may be manufactured by performing secondary bonding by thermal compression of the first substrate (210), the second-third substrate (220c), and the second-second substrate (220b).

According to the third embodiment, the power semiconductor device may be disposed between the substrate (210), the second-third substrate (220c) and the second-second substrate (220b). Since additional structures such as spacers that overlap vertically with the power semiconductor device may be omitted, the problem of assembly failure due to the height variation of the components of the power semiconductor module can be prevented. In addition, the pressure applied to the power semiconductor device or the substrate during the pressing process with the press jig can be reduced, so there is the technical effect of preventing thermal, mechanical, and electrical reliability problems.

Next, the first heat dissipation post (311) and the second heat dissipation post (312) may be disposed on the second-third substrate (220c) and the second-second substrate (220b), respectively. For example, the first heat dissipation post (311) and the second heat dissipation post (312) may be respectively positioned at positions overlapping the first power semiconductor device (100a) and the second power semiconductor device (100b) from above and below. The heat dissipation post (310) may be made of a metal material such as Cu, but is not limited thereto.

The heat dissipation post (310) may be bonded to the second substrate (220) using a predetermined adhesive. In addition, the heat dissipation post (310) may be bonded through ultrasonic bonding so that less pressure or heat may be transferred to the first power semiconductor device (100a) or the second power semiconductor device (100b).

Next, a preliminary molding material (not shown) such as EMC may be overcoated to a position higher than the heat dissipation post (310) using a molding housing. Afterwards, as shown in FIG. 8, the preliminary molding material may be ground to form the first molding member (320) so that the heat dissipation post (310) may be exposed.

According to the third embodiment, the molding material is formed to overcoat the heat dissipation post to a position higher than the heat dissipation post, after then the molding material is ground so that the heat dissipation post may be exposed. There is a technical effect of preventing the appearance defect of the EMC molding. In addition, the embodiment has a technical effect that the height of the heat dissipation post may be controlled in consideration of the product specification, and the thickness or height of the product specification may be accurately controlled as the molding process progresses thereafter.

In addition, in the third embodiment, the second plate of the second-third substrate (220c) or the second-second substrate (220b) in contact with the heat dissipation post (310) may be grounded. Accordingly, according to the third embodiment, a metal heat dissipation post capable of blocking static electricity or electromagnetic waves may be disposed in a position that overlaps the power semiconductor device in the vertical direction, and the plate of the second-third substrate (220c) or the second-second substrate in contact with the heat dissipation post may be grounded, thereby preventing malfunctions of high-speed switching of the power semiconductor device in the power semiconductor module due to EMI or EMS problems.

### (Fourth embodiment)

Next, FIG. 9 is a cross-sectional view of the power semiconductor module (504) according to the fourth embodiment. The fourth embodiment may adopt the technical features of the first to third embodiments, and the main features of the fourth embodiment will be described below.

Referring to FIG. 9, the power semiconductor module (504) according to the fourth embodiment may include the first substrate (210), the second-third substrate (220c), the second-second substrate (220b), the conductive frame (250), and the heat dissipation post (310). A plurality of power semiconductor devices (100) may constitute one sub-module. The first substrate (210), the second-third substrate (22c), and the second-second substrate (220b) may be heat dissipation substrates.

The fourth embodiment may include the first molding member (320) surrounding the first substrate (210), the second-third substrate (220c), the second-second substrate (220b), and the conductive frame (250).

The manufacturing process of the fourth embodiment (504) below may be the same as the process of forming the first molding member (320) by grinding the preliminary molding material of the third embodiment so that the heat dissipation post (310) may be exposed (see FIG. 7).

Afterwards, the fourth embodiment may form the second molding member (320B) by forming the molding recess (320R) by a laser drilling process or the like on the first molding member (320). According to the fourth embodiment, there is a technical effect of further improving the heat dissipation efficiency as the side of the heat dissipation post (310) may be exposed by the molding recess (320R).

In addition, according to the fourth embodiment, the power semiconductor device may be disposed between the first substrate (210), the second-third substrate (220c), and the second-second substrate (220b), and since additional structures such as spacers that overlap vertically with the power semiconductor device may be omitted, the problem of assembly failure due to the height variation of the components of the power semiconductor module can be prevented. In addition, since the pressure applied to the power semiconductor device or the substrate during the pressing process with the press jig can be reduced, there is a technical effect of preventing thermal, mechanical, and electrical reliability problems.

In addition, according to the fourth embodiment, the molding material is formed to overcoat the heat dissipation post to a position higher than the heat dissipation post, after then the molding material is ground such that the heat dissipation post may be exposed. So, the occurrence of appearance defects in the EMC molding can be prevented. In addition, the embodiment has a technical effect of controlling the height of the heat dissipation post in consideration of the product specifications, and accurately controlling the thickness or height of the product specifications as the molding process proceeds thereafter.

In addition, according to the fourth embodiment, a metal heat dissipation post capable of blocking static electricity or electromagnetic waves may be disposed in a position that overlaps the power semiconductor device in a vertical direction, and the plate of the second-third substrate or the second-second substrate in contact with the heat dissipation post may be grounded, thereby preventing malfunctions of high-speed switching of the power semiconductor device in the power semiconductor module due to EMI or EMS problems.

### (Fifth embodiment)

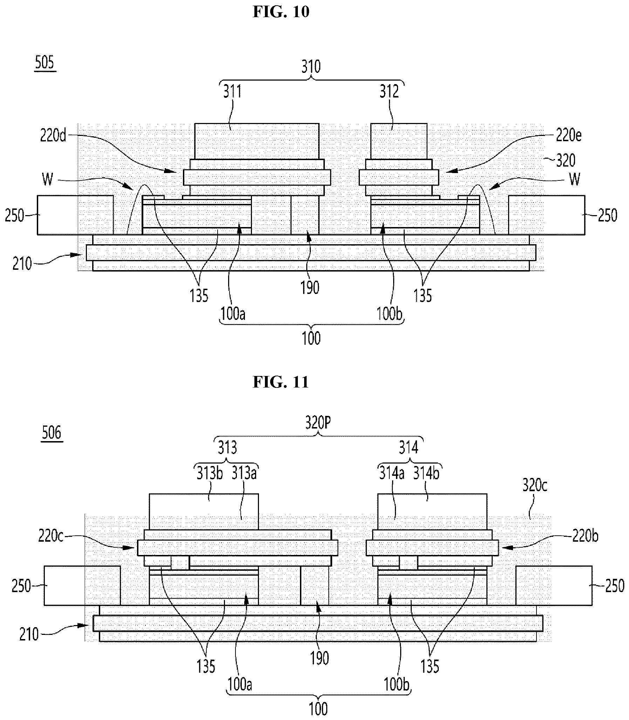

Next, FIG. 10 is a cross-sectional view of a power semiconductor module (505) according to the fifth embodiment. The fifth embodiment may adopt the technical features of the first to fourth embodiments, and the main features of the fifth embodiment will be described below.

Referring to FIG. 10, the power semiconductor module (505) according to the fifth embodiment may include the first substrate (210), a second-fourth substrate (220d), a second-fifth substrate (220e), the conductive frame (250), and the heat dissipation post (310). A plurality of power semiconductor devices (100) may constitute one sub-module. The first substrate (210), the second-fourth substrate (220d), and the second-fifth substrate (220e) may be heat dissipation substrates.

The fifth embodiment may include the first molding member (320) that surrounds the first substrate (210), the second-fourth substrate (220d), the second-fifth substrate (220d), and the conductive frame (250).

The first power semiconductor device (100a) may be disposed between the first substrate (210) and the second-fourth substrate (220d) and may be bonded by an adhesive member (135). In addition, the second power semiconductor device (100b) may be disposed between the first substrate (210) and the second-fifth substrate (220e) and may be bonded by an adhesive member (135). The first adhesive member (135) may be a Sn-Ag based adhesive member or an Ag based adhesive member.

Hereinafter, the technical features will be described in detail while explaining the manufacturing process of the fifth embodiment (505).

Referring to FIG. 10, the first power semiconductor device (100a), the conductive member (190), the second power semiconductor device (100b), and the conductive frame (250) may be bonded by the first adhesive member (135) on the first substrate (210) using a pick-up tool. The conductive member (190) can include a metal material such as Cu.

Afterwards, the second-fourth substrate (220d) and the second-fifth substrate (220e) may be disposed on the first power semiconductor device (100a) and the second power semiconductor device (100b), respectively.

The second-fourth substrate (220d) may be disposed on the source electrode and the conductive member (190) of the first power semiconductor device (100a).

In addition, the second-fifth substrate (220e) may be disposed on the source electrode of the second power semiconductor device (100b).

Afterwards, a sintering process may be performed while performing thermal compression (P) through a predetermined press jig. For example, a power semiconductor module may be manufactured by performing secondary bonding by thermal compression of the first substrate (210), the second-fourth substrate (220d), and the second-fifth substrate (220e).

After this, the gate electrode of the first power semiconductor device (100a) and the circuit pattern of the first substrate may be connected by a wire (W). Also, the gate electrode of the second power semiconductor device (100b) and the circuit pattern of the first substrate may be connected by a wire (W).

According to the fifth embodiment, the power semiconductor device may be disposed between the first substrate (210) and the second-fourth substrate (220d), and the second-fifth substrate (220e). Since additional structures such as spacers that overlap vertically with the power semiconductor device may be omitted, the problem of assembly failure due to the height variation of the components of the power semiconductor module can be prevented. In addition, since the pressure applied to the power semiconductor device or the substrate during the pressing process with the press jig can be reduced, there is a technical effect of preventing thermal, mechanical, and electrical reliability problems.

Next, the first heat dissipation post (311) and the second heat dissipation post (312) may be disposed on the second-fourth substrate (220d) and the second-fifth substrate (220e), respectively. For example, the first heat dissipation post (311) and the second heat dissipation post (312) may be disposed at positions that overlap the first power semiconductor device (100a) and the second power semiconductor device (100b) respectively. The heat dissipation post (310) may be made of a metal material such as Cu, but is not limited thereto.

The heat dissipation post (310) may be bonded to the second substrate (220) using a predetermined adhesive material. In addition, the heat dissipation post (310) may be bonded through ultrasonic bonding so that less pressure or heat may be transferred to the first power semiconductor device (100a) or the second power semiconductor device (100b).

Next, a preliminary molding material such as EMC may be overcoated to a position higher than the heat dissipation post (310) using a molding housing. Afterwards, the preliminary molding material may be ground to form the first molding member (320) so that the heat dissipation post (310) may be exposed.

According to the fifth embodiment, the molding material is formed to overcoat the heat dissipation post to a position higher than the heat dissipation post, after then the molding material is ground so that the heat dissipation post may be exposed. So, the occurrence of appearance defects in the EMC molding can be prevented. In addition, the embodiment has a technical effect of controlling the height of the heat dissipation post in consideration of the product specifications, and accurately controlling the thickness or height of the product specifications as the molding process proceeds thereafter.

In addition, in the fifth embodiment, the heat dissipation post (310) or the second plate of the second-fourth substrate (220d) or the second-fifth substrate (220e) in contact with the heat dissipation post (310) may be grounded. Accordingly, according to the fifth embodiment, a metal heat dissipation post capable of blocking static electricity or electromagnetic waves may be disposed at a position vertically overlapping the power semiconductor device, and the heat dissipation post or the second plate of the second-fourth substrate (220d) or the second-fifth substrate (220e) in contact with the heat dissipation post may be grounded. So, there is a special technical effect that can prevent a problem of malfunction in the power semiconductor device, such as EMI or EMS problems, in the high-speed switching of the power semiconductor device.

### (Sixth embodiment)

Next, FIG. 11 is a cross-sectional view of a power semiconductor module (506) according to the sixth embodiment. The sixth embodiment may adopt the technical features of the first to fifth embodiments, and the following description will focus on the main features of the sixth embodiment.

Referring to FIG. 11, the power semiconductor module (506) according to the sixth embodiment may include the first substrate (210), the second-third substrate (220c), the second-second substrate (220b), the conductive frame (250), and a protruding heat dissipation post (320P). A plurality of power semiconductor devices (100) may constitute one sub-module. The first substrate (210), the second-third substrate (220c), and the second-second substrate (220b) may be heat dissipation substrates.

The sixth embodiment may include a third molding member (320C) surrounding the first substrate (210), the second-third substrate (220c), the second-second substrate (220b), and the conductive frame (250).

In the sixth embodiment, the third molding member (320C) may be formed by an injection molding method using a predetermined mold frame (not shown) rather than an overcoating method. For example, the third molding member (320C) may be formed by injecting a mold into a predetermined mold frame. The height of the third molding member (320C) may be lower than the height of the protruding heat dissipation post (320P).

Accordingly, the protruding heat dissipation post (320P) may include a third heat dissipation post (313) and a fourth heat dissipation post (314), and may include an area covered by the third molding member (320C) and an area exposed thereto.

For example, the third heat dissipation post (313) may include a third-first heat dissipation post (313a) disposed on an inner side of the third molding member (320C) and a third-second heat dissipation post (313b) disposed on an outer side of the third molding member (320C).

In addition, the fourth heat dissipation post (314) may include a fourth-first heat dissipation post (314a) disposed on an inside of the third molding member (320C) and a fourth-second heat dissipation post (314b) disposed on an outside of the third molding member (320C).

According to the sixth embodiment, there is a technical effect of further improving heat dissipation efficiency as the top surface of the heat dissipation post (320P) protruded by the third molding member (320C) may be exposed.

In addition, according to the sixth embodiment, the power semiconductor device may be disposed between the first substrate (210), the second-third substrate (220c), and the second-second substrate (220b). Since additional structures such as spacers that overlap vertically with the power semiconductor device may be omitted, the problem of assembly failure due to the height variation of the components of the power semiconductor module can be prevented. In addition, since the pressure applied to the power semiconductor device or the substrate during the pressing process with the press jig can be reduced, there is a technical effect of preventing thermal, mechanical, and electrical reliability problems.

In addition, according to the sixth embodiment, the height of the protruding heat dissipation post may be controlled in consideration of the product specifications, and through this, there is a technical effect that can accurately control the thickness or height of the product specifications.

In addition, according to the sixth embodiment, a metal heat dissipation post capable of blocking static electricity or electromagnetic waves may be disposed in a position that overlaps the power semiconductor device in the vertical direction, and the protruding heat dissipation post (320P) or the second plate of the second-third substrate (220c) or the second-second substrate (220b) that comes into contact with the protruding heat dissipation post (320P) may be grounded. So, there is a special technical effect that can prevent malfunctions of high-speed switching of the power semiconductor device in the power semiconductor module due to EMI or EMS problems.

The main technical features of the first to sixth embodiments may be summarized as follows.

According to the embodiment, there is a technical effect that can prevent assembly failure or thermal, mechanical, and electrical reliability problems due to height variation of components of the power semiconductor module.

For example, according to the embodiment, the power semiconductor device may be disposed between the first substrate (210) and the second substrate (220). Since additional structures such as separate spacers may be omitted, there is a technical effect that can prevent assembly failure problems due to height variation of components of the power semiconductor module.

In addition, according to the embodiment, the power semiconductor device may be disposed between the first substrate (210) and the second substrate (220). Since additional structures such as separate spacers may be omitted, the pressure applied to the power semiconductor device or the substrate during the pressing process using the press jig can be reduced, and thus there is a technical effect that can prevent thermal, mechanical, and electrical reliability problems.

In addition, according to the embodiment, since the heat dissipation post may be disposed at a position corresponding to the vertical direction of the power semiconductor device in consideration of the heat dissipation distribution on the substrate, the heat dissipation performance may be improved.

Also, according to the embodiment, there is a technical effect that can prevent malfunctions of high-speed switching of the power semiconductor device in the power semiconductor module due to EMI or EMS problems.

For example, according to the embodiment, since the metal heat dissipation post capable of blocking static electricity or electromagnetic waves may be disposed in a position that overlaps the power semiconductor device in a vertical direction, there is a technical effect that can prevent malfunctions of high-speed switching of the power semiconductor device in the power semiconductor module due to EMI or EMS problems.

For example, according to the embodiment, since the metal heat dissipation post capable of blocking static electricity or electromagnetic waves may be disposed in a position that overlaps the power semiconductor device in a vertical direction, and the second plate (220m) of the second substrate (220) that comes into contact with the heat dissipation post may be grounded, there is a special technical effect that can prevent malfunctions of high-speed switching of the power semiconductor device in the power semiconductor module due to EMI or EMS problems.

In addition, according to the embodiment, the molding material may be formed to overcoat the heat dissipation post to a position higher than the heat dissipation post, after then the molding material may be ground so that the heat dissipation post may be exposed. So, the occurrence of appearance defects in the EMC molding can be prevented.

In addition, the embodiment can control the height of the heat dissipation post in consideration of the product specifications, and there is a technical effect that can accurately control the thickness or height of the product specifications as the molding process proceeds thereafter.

Although the above has been described with reference to the embodiment of the present invention, it will be easily understood by those skilled in the art that the present invention may be variously modified and changed within the scope that does not depart from the scope of the present invention described in the scope of the following patent claims.

## Claims

1. A power semiconductor module comprising:
a first substrate;
a power semiconductor device bonded to the first substrate;
a second substrate bonded to the power semiconductor device;
a heat dissipation post bonded to the second substrate; and
a molding member surrounding the first substrate, the power semiconductor device, the second substrate, and the heat dissipation post,
wherein a top surface of the heat dissipation post is exposed from a top surface of the molding member.

2. The power semiconductor module according to claim 1, wherein a height of the top surface of the heat dissipation post is the same as that of the top surface of the molding member.

3. The power semiconductor module according to any one of claims 1 to 2, wherein the heat dissipation post is configured to vertically overlap the power semiconductor device.

4. The power semiconductor module according to any one of claims 1 to 3, wherein the heat dissipation post is grounded.

5. The power semiconductor module according to any one of claims 1 to 4, wherein the second substrate comprises a metal plate, and
wherein the metal plate of the second substrate is grounded.

6. The power semiconductor module according to any one of claims 1 to 5, wherein the power semiconductor device comprises a first power semiconductor device and a second power semiconductor device spaced apart from each other on the first substrate.

7. The power semiconductor module according to claim 6, wherein the second substrate comprises a second-first substrate bonded to the first power semiconductor device and a second-second substrate spaced apart from the second-first substrate and bonded to the second power semiconductor device; and/or
wherein the second substrate comprises a second-second substrate bonded to the second power semiconductor device and a second-third substrate spaced apart from the second-second substrate and bonded to the first power semiconductor device, and wherein the power semiconductor device further comprises a conductive member between the first substrate and the second-third substrate.

8. The power semiconductor module according to any one of claims 1 to 7, wherein the molding member comprises a molding recess on a top surface thereof, and
wherein a side surface of the heat dissipation post is exposed through the molding recess.

9. The power semiconductor module according to any one of claims 1 to 8, wherein a gate electrode of the power semiconductor device is electrically connected to the first substrate by a wire.

10. The power semiconductor module according to any one of claims 1 to 9, wherein a top surface of the heat dissipation post is higher than that of the molding member.

11. The power semiconductor module according to claim 10, wherein the heat dissipation post protruding higher than the top surface of the molding member comprises a third-first heat dissipation post disposed inside the molding member and/or a third-second heat dissipation post arranged outside the molding member.

12. The power semiconductor module according to any one of claims 1 to 11, wherein the second substrate comprises a metal plate, and
wherein the heat dissipation post is in contact with the metal plate of the second substrate.

13. The power semiconductor module according to claim 12, wherein the metal plate of the second substrate is grounded.

14. The power semiconductor module according to any one of claims 1 to 13, wherein the heat dissipation post is grounded.

15. A power converter including the power semiconductor module according to any one of claims 1 to 14.
